**Europäisches Patentamt**

**European Patent Office**

**Office européen des brevets**

(19)

(11) Publication number : **0 503 820 A1**

## (12) EUROPEAN PATENT APPLICATION

(21) Application number : **92301810.5**

(22) Date of filing : **03.03.92**

(51) Int. Cl.$^5$ : **C23C 16/44,** C23C 16/50, C23C 16/40

(30) Priority : **12.03.91 US 667837**

(43) Date of publication of application :
**16.09.92 Bulletin 92/38**

(84) Designated Contracting States :
**AT BE CH DE ES FR GB IT LI LU NL SE**

(71) Applicant : **THE BOC GROUP, INC.**
**575 Mountain Avenue**
**Murray Hill New Jersey 07974 (US)**

(72) Inventor : **Pender, Milam**
**6114 Allbrook Circle**
**Pleasanton, California 94588 (US)**
Inventor : **Countrywood, Joseph**
**3536 Twin Oaks Drive**
**Napa, California 94558 (US)**

(74) Representative : **Bousfield, Roger James et al**
**The BOC Group plc Chertsey Road**
**Windlesham Surrey GU20 6HJ (GB)**

(54) **Plasma enhanced chemical vapour deposition device.**

(57)   A plasma enhanced chemical vapour deposition device for coating large three-dimensional substrates is provided. The device includes elongated metal rod cathodes 20 each having an aperture 30 at one end that is in communication with a process gas source, with the aperture extending substantially the length of the rod to form a substantially cylindrical bore within the rod, wherein the bore is in communication with the rod exterior through a series of holes 26 in the rod 20, and wherein the diameter of the holes is substantially less than the bore diameter so that the gas pressure is substantially uniform throughout the bore during the deposition process. The rod cathodes, which are situated within an evacuable coating chamber, are arranged in a readily expandable matrix into which substrates 29 to be coated are positioned.

FIG._2.

EP 0 503 820 A1

The present invention relates generally to plasma enhanced chemical vapour deposition and more particularly to rod cathode devices useful for internal process gas distribution in plasma enhanced chemical vapour deposition.

Plasma enhanced chemical vapour deposition (PECVD) is a technique for the deposition of insulation films such as silicon nitrate and silicon oxide. The major advantage of PECVD is its lower temperature capability compared to that of thermally driven CVD. PECVD has been particularly important in the deposition of thin films for microelectronics. In early microelectronic PECVD reactors, the plasma is generated between two parallel, circular electrodes. The wafers are loaded onto the lower, electrically grounded electrode. The upper electrode is connected to a rf generator through an impedance matching network. The reactants are fed in from a gas ring, enter the plasma region (ie., the region between the electrodes) at its outer edge, and flow radially in toward a pumping port at the centre of the electrode. These reactors are commonly known as "radial flow" reactors.

In the "inverse" radial flow reactor, the gas inlet is at the centre of the lower electrode, with the gas flow directed radially outward. A magnetic drive assembly permits rotation of the lower electrode, thus randomising the substrate position and optimising deposition uniformity.

Finally, in hot-wall, batch PECVD systems, the deposition chamber consists of a quartz tube placed within a resistively heated furnace. Vertically oriented graphite slabs carry the wafers in slots. Every other slab is connected to the same rf power terminal and a glow discharge is generated between adjacent electrodes. The reactants are directed along the axis of the chamber tube and between the electrodes.

Recently, PECVD has been employed to coat large substrates, eg., plastic containers. In one process, plasma polymerisation is used to deposit silicon oxide based thin films from volatile organosilicon compounds. This method of depositing an adherent, hard silicon oxide based film comprises providing a gas stream with a number of components, establishing a glow discharge plasma derived from the gas stream, or one of its components, in a previously evacuated chamber with a substrate removably positioned in the plasma, and controllably flowing the gas stream into the plasma to deposit a silicon oxide onto the substrate when positioned in the plasma. The gas stream includes a volatilised organosilicon compound, oxygen, and an inert gas such as helium or argon.

The gas stream is controllably flowed into the plasma by volatilising the organosilicon exterior the chamber and admixing metered amounts with oxygen and the inert gas. Controlling the flowing gas stream into the plasma preferably includes adjusting the amount of organosilicon entering the chamber during the deposition.

With large scale PECVD systems, much heat is generated that must be removed during the deposition process. Moreover, in order to create more effective ionisation, the process gas should be introduced where the electric field is the strongest. Furthermore, in coating large three dimensional substrates, it is important that the cathodes be strategically positioned around the substrates in order to provide for uniform coating.

It is the object of the present invention to provide a PECVD device for reproducibly depositing adherent, uniform thin films at commercially feasible deposition rates on large three-dimensional substrates.

It is another object of the present invention to provide devices that distribute process gas into the PECVD chamber where the electric field is the strongest to create more effective ionisation and that facilitate cooling during PECVD.

It is a further object of the present invention to provide a PECVD device in which the process gas is distributed in the PECVD chamber through rod cathodes.

It is a still further object to provide a system of cathodes for coating substrates simultaneously wherein the system can be readily expanded to accommodate more substrates.

These and other objects are accomplished with the present invention which comprises a cathode system useful for distributing gas in a chemical vapour deposition process for coating three dimensional substrates. The system comprises elongated metal rods arranged in an array wherein the rods are sufficiently spaced apart so that the substrates placed therein are uniformly distributed in the array. Each elongated metal rod has an aperture at one end that is in communication with the process gas source; the aperture extending substantially the length of the rod to form a substantially cylindrical bore within the rod. Moreover, the bore is in communication with the rod exterior through a series of holes in the rod, with the diameter of the holes being substantially less than the bore diameter so that the gas pressure is substantially uniform throughout the bore during the deposition process.

PECVD with the inventive device provides durable silicon based compound coatings, referred to as quartz-like film, which can be deposited at relatively high rates. Containers coated with the durable silicon based compound exhibit excellent oxygen barrier protection.

Figure 1 schematically illustrates the plasma deposition chamber and its associated equipment;
Figure 2 is a partial side sectional view of the plasma deposition chamber and rod cathodes attached thereto;
Figure 3 is an array of cathodes arranged to provide uniform coating of three dimensional substrates; and

Figure 4 is a top plan view of Figure 3.

The present invention provides a device for depositing films particularly silicon oxide based films that are hard, adherent, and preferably substantially inorganic. The inventive device will be described with respect to depositing silicon oxide based films; however, it is understood that the invention is applicable to PECVD in general and is not limited by any particular film deposited.

When depositing silicon oxide based films with the inventive device, an organosilicon compound can be used as a starting material. Moreover, the substantially inorganic silicon oxide based films deposited are often characterised by a high degree of crosslinking.

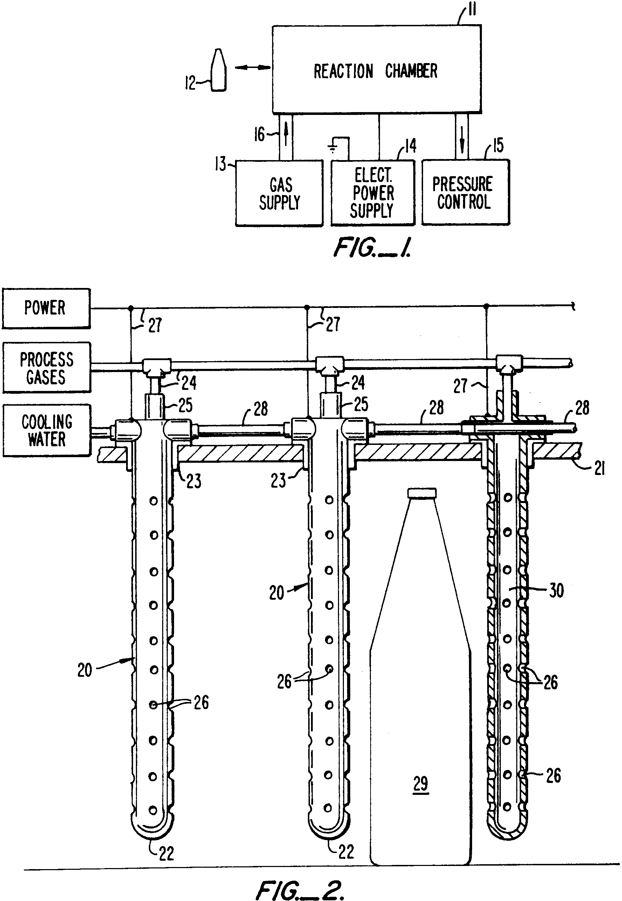

Referring initially to Figure 1, a PECVD system is schematically illustrated that includes an enclosed reaction chamber 11 in which a plasma is formed and in which a substrate, such as substrate 12, is placed for depositing a thin film of material on it. The substrate 12 can be any vacuum compatible material such as metal, glass, some plastics, and other coated substrates. One or more gases are supplied to the reaction chamber by a gas supply system 13 via inlet conduit 16. An electric filed is created by a power supply 14, and a low pressure is maintained by a pressure control system 15. The reaction chamber 11 can be manufactured from any appropriate material to perform PECVD. The power supply has its output connected between the cathode rods (described below) and a metallic body of the reaction chamber.

Figure 2 illustrates the attachment of inventive cathodes 20 to the upper chamber cover 21. Each cathode comprises a metal rod with a cylindrical bore 30 therein. The end 22 of the cathode rod, which is situated away from the chamber cover 21 is sealed. The cathode is preferably made of copper but can be manufactured from any suitable metal. As is apparent, each cathode is partially inserted into the chamber through an aperture in the chamber cover 21. Electrically insulated 0-ring spacer 23 positioned between the rod and the aperture of the chamber cover provides a seal of the aperture.

Besides functioning as a cathode, the rods 20 also facilitate process gas distribution within the chamber. As shown in Figure 2, process gas conduits 24 are connected to the process gas supply. The conduits are part of a gas manifold system situated above the chamber cover 21 that uniformly channels gas to each cathode rod. The cylindrical bore 30 of each rod is connected to the gas manifold through conduit 24; gas flow into each bore is regulated by flow restrictor 25. The process gas enters the chamber through a series of holes 26 in the rod. The diameters of the holes should be substantially less than the bore diameter so that the gas pressure is substantially uniform throughout the bore during the deposition process.

The sizes of the hole diameters in Figure 2 are exaggerated. Moreover, the number of holes and their locations along the-rod should be such that gas will be distributed evenly in the region surrounding each cathode rod. This leads to more effective ionisation of the process gases since they are introduced into the strongest regions of the electric field. The length of the cathode rods should be comparable to that of the substrates. During the deposition process, a film will also develop on the rod cathodes; therefore, the rods should be cleaned periodically.

The power supply source is connected to the rods through leads 27. The leads are connected to screw holes in the rods that are bolted. During the PECVD process, some of the heat which is generated at the cathode rod is removed by coolant. As shown in Figure 2, a portion of the cathode rod situated above the chamber cover 21 has a "T" configuration; and through the horizontal portion of this "T" is pathway 31 (which is not in communication with the bore or gas conduit) through which coolant flows. The pathways of different rods are connected by line 28. Deionised water is commonly used as a coolant. Dissipation of heat during the process improves PECVD efficiency.

Choice of the substrate to be coated by the invention will vary according to the desired application. However, as is apparent, the invention is particularly suited for three-dimensional substrates. For example, plastics containers made from polypropylene, polyethyleneterephthalate (PET) or polycarbonate (PC) that are useful for packaging foods or beverages may be coated in accordance with the invention to prevent oxygen or moisture permeation. Substrate 29 in Figure 2 can be a plastic beverage bottle.

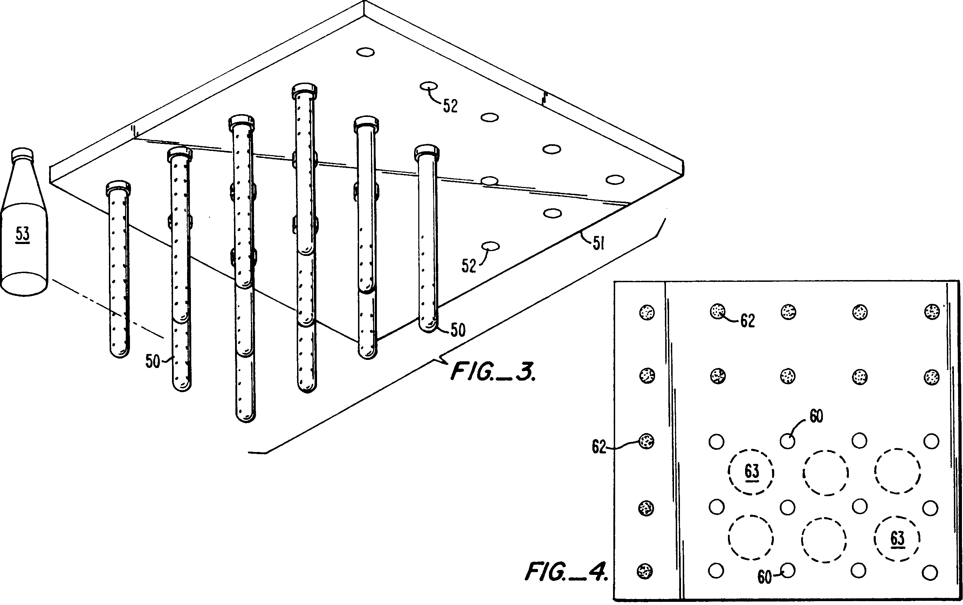

Shown in Figure 3 is an array of cathodes 50 that is attached to the upper chamber cover 51 of an evacuable chamber. The array comprises twelve cathodes arranged in a 3 x 4 matrix. This arrangement can accommodate up to six three dimensional substrates 53 each positioned between four rods. Thus each substrate is exposed to process gas from four different directions. Sites 52 are positions in the chamber cover where additional cathodes can be mounted. Normally these sites are sealed.

Shown in Figure 4 is a top plan representation of the chamber cover, cathode array, and sealed apertures as shown in Figure 3. Substrates 63 are situated in the matrix of cathode rods 60 so that each substrate 63 is approximately equal distance to four rods. This arrangement provides that during deposition, the process gas will be introduced where the electric field is the strongest, creating more effective ionisation. In this fashion, the uniformity of the coating on each three dimensional substrate is improved. As shown in Figure 4, the chamber can accommodate thirteen additional cathodes at the sealed aperture sites 62. As is apparent, using more cathodes would accommodate more substrates; mounting thirteen additional cathodes would accommodate ten more substrates.

This provides an easy method of increasing the number of substrates that can be coated simultaneously. Moreover, as is apparent, the employment of rods in this fashion allows the inventive device to be scaled readily; that is, the inventive device can be one comprising a small chamber with only a few cathode rods or a large chamber with may rods. Furthermore, regardless of the number of rods employed, each individual substrate is subject to the same coating environment created by four surrounding cathode rods. Finally, the chamber cover is ordinarily removable so as to be easily replaced by another chamber cover which contains a different array of cathode rods attached thereto. In this fashion, by simply changing chamber covers, an evacuable chamber can be readily modified to accommodate different size substrates.

To facilitate handling the substrates, the substrates can be secured on cassettes, pallet-like structures, which can be moved readily into and out of the evacuable chamber. Means can also be provided to rotate the substrates during deposition which further promotes uniformity of the film that is deposited. Generally, after the substrates to be coated are loaded into the chamber, a mechanical pump is used to reduce the pressure most of the way to the high vacuum region. Gaseous components necessary for the plasma to form are introduced through the holes in the rod cathodes. A glow discharge plasma is thereafter established in the chamber.

The inventive device provides durable silicon based compound coatings, referred to as quartz-like film. which can be deposited at relatively high rates. To demonstrate the device's effectiveness, films of silicon oxide were coated onto the outer surfaces of different container substrates and the films were tested for gas permeation (barrier protection) properties. Experiments were conducted in a PECVD apparatus that was manufactured by Airco Coating Technology, a division of assignee.

The apparatus comprises a steel evacuable chamber with a chamber cover onto which 140 cathode rods are mounted. The rods are positioned in an array which forms a 10 x 14 matrix which can accommodate up to 117 substrates. Each copper cathode rod is approximately 1 inch in diameter and has an inner bore that is approximately 3/4 inch in diameter. The exposed portion of each rod, that is, the portion which is inside the chamber, is approximately 14 1/2 inches long. As described above, process gas is distributed into the chamber through a series of holes in the rod; in this system, the holes are arranged in rows that are approximately 1.5 inch apart along the length of the rod, with each row comprising 6 holes spaced evenly apart. The distance between successive cathode rods (centre-to-centre) of one row to the next is approximately 6 3/4 inches and the distance between successive cathode rod (centre-to-centre) of one column to the next is approximately 4 1/2. These are optimised dimensions for coating the plastic containers to be described below. The rod cathodes can be powered by a supply capable of delivering alternating current of a frequency from about 40 kHz to about 13.56 MHz, and is typically 50 kHz. Total power per rod can be 10 to 200 watts, and is typically 45-90 watts/rod.

The process gas used comprises a mixture of three gases, namely, 1,1,3,3-tetramethyldisioloxane (TMDSO), oxygen, and helium. With the TMDSO, a vaporiser is employed to vaporise the liquid before it is admixed with the oxygen and helium. During deposition the gas mixture enters the chamber at approximately 2672 SCCM, with the TMDSO, oxygen, and helium entering at approximately 122, 1050, and 1500, respectively. Moreover, during deposition the operating conditions for the PECVD apparatus are: Power: 6.7 kW and Pressure: 35 microns. The pressure can range from approximately from 10 to 50 microns. At this range, the process gas flow is low enough to permit plasma formation but high enough to avoid starving the species. The chamber and cathode rods are at ambient temperature at the start of deposition but rises despite cooling of the rods. Normally, high temperatures should be avoided as damage to the substrates, particularly those made from plastic, can occur.

Three types of commonly available containers were coated, namely: (1) 83 mm finish 32 ounce mayonnaise jar; (2) standard ketchup jar; and (3) one-half litre carbonated soft drink (CSD) bottle. The containers were all made from PET. During the deposition process, heat accumulates within the chamber and to avoid distorting or otherwise damaging the PET containers by prolong exposure to high temperatures, deposition is normally carried out for approximately ten minutes. If thicker coatings are desired, deposition can resume after the system has cooled. It has been found that the thickness of the coatings after ten minutes of deposition is approximately 1300 Å for all three containers. This film thickness appears to be adequate for many commercial food applications.

Oxygen barrier protection for each of the three types of coated containers were measured as follows. First, the coated jar was sealed with a device which has an inlet and outlet. The inlet was connected to a source of nitrogen gas and the outlet was connected to a gas detection device which is sensitive to oxygen. Second, nitrogen gas was continuously pumped into the jar through the inlet and the amount of oxygen in the outlet stream was monitored. The pressure inside and outside the jar was the same so that no pressure gradient existed to influence oxygen permeation. In the first few minutes, which is regarded as the purging phase, the outlet stream contains much oxygen. Next comes the second phase during which some of the oxygen that saturates the PET material of the jar begins to enter the jar. After about 4 weeks, the amount of oxygen at the outlet stream reaches a steady-state value. For the jars tested, equilibrium was deemed reached when the fluctuation in the amount of oxygen measured was less than 1 microlitre per jar (package) per day. At this point, it was considered that the atmosphere was the sole source of the oxygen in the outlet stream and the amount of oxygen in the outlet stream was a measure of oxygen permeation.

A means of gauging the effectiveness of a particular coating on a particular substrate as an oxygen barrier is to measure the barrier improvement, X, which is defined as the ratio of the amount of oxygen permeation of the uncoated substrate to the amount of oxygen permeation after being coated. An uncoated 83 mm finish 32 ounce mayonnaise jar was measured for oxygen permeation by the above described method, and the oxygen permeation was found to be 30 $\mu$l/day for each jar (package). A total of 83 coated jars were tested and yield the following data:

mean $O_2$ permeation = 7.6 $\mu$l/package/day

$\sigma$ (standard deviation) = 1.77 $\mu$l/package/day

Thus, for the 83 mm 32 ounce mayonnaise jar, the mean barrier improvement was 3.95 (30/7.6). For many commercial applications, a barrier improvement of 3 or better is adequate. In these experiments, of the 83 jars tested, approximately 92% had barrier improvement of 3 or better.

Similar experiments were conducted for the ketchup jar and CSD bottle. For the ketchup jar the mean barrier improvement was approximately 6 and for the CSD the mean barrier improvement was approximately 10. As is apparent, barrier improvement is substrate dependent.

Other suitable organosilicon compounds that can be employed in the gas stream include methylsilane, dimethylsilane, trimethylsilane, diethylsilane, propylsilane, phenylsilane, hexamethyldisilane, 1,1,2,2-tetramethyl disilane, bis(trimethylsilyl) methane, bis (dimethylsilyl) methane, hexamethyldisiloxane, vinyl trimethoxy silane, vinyl triethoxy silane, ethylmethoxy silane, ethyltrimethoxy silane, divinyltetramethyldisiloxane, divinylhexamethyltrisiloxane, and trivinylpentamethyl-trisiloxane. These compounds are liquid at about ambient temperature, have a boiling point above about ambient temperature.

Among the preferred organosilicons are 1,1,3,3-tetramethyldisiloxane, hexamethyldisiloxane, vinyltrimethylsilane, methyltrimethoxysilane, vinyltrimethoxysilane, and hexamethyldisilazane.

The volatilised organosilicon component is preferably admixed with the oxygen component and the inert gas component before being flowed into the chamber. The quantities of these gases being so admixed are controlled by flow controllers so as to adjustably control the flow rate ratio of the gas stream components.

It is to be understood that while the invention has been described above in conjunction with preferred specific embodiments, the description and the examples are intended to illustrate and not limit the scope of the invention, which is defined by the scope of the appended claims.

## Claims

1. A chemical vapour deposition device used for coating three dimensional substrates comprising:
   an evacuable coating chamber;
   a gas source;
   an elongated metal rod, within said chamber, having an aperture at one end that is in communication with said gas source, with the aperture extending substantially the length of the rod to form a substantially cylindrical bore within the rod, wherein the bore is in communication with the rod exterior through a series of holes in the rod, and wherein the diameter of the holes is substantially less than the bore diameter so that gas pressure is substantially uniform throughout the bore during the deposition process; and
   a power source that is connected to said coating chamber and said metal rod.

2. The chemical vapour deposition device as defined in Claim 1 further comprising a heat transfer network to facilitate removal of heat that is generated during the deposition process.

3. The chemical vapour deposition device as defined in Claim 2 wherein the heat transfer network comprises a coolant manifold in contact with said elongated metal rod.

4. A cathode system useful for distributing gas in a chemical vapour deposition process for coating three dimensional substrates comprising:
   elongated metal rods arranged in a rectangular matrix having m by n dimensions, wherein m and n are integers equal to or greater than 2, wherein the number of rods in the system is equal to the product of m and n, and wherein the rods are positioned at the matrix vertices and are sufficiently spaced apart so that the individual substrates can be placed in the matrix interstitial spaces.

5. The cathode system as defined in Claim 4 wherein each of said metal rods has an aperture at one end that is in communication with said gas source, with the aperture extending substantially the length of the rod to form a cylindrical bore within the rod, wherein the bore is in communication with the rod exterior through a series of holes in the rod, and wherein the diameter of each hole is substantially less than the bore diameter so that gas pressure is substantially the same throughout the bore during the process.

6. The cathode system as defined in Claim 5 further comprises a heat transfer network in contact with said metal rod to facilitate removal of heat that is generated during the deposition process.

7. The cathode system as defined in Claim 6 wherein the heat transfer network comprise a coolant manifold.

8. The system of cathodes as defined in Claim 7 wherein the metal rods are connected to a power supply source.

9. A method for depositing a film onto three dimensional substrates in plasma enhanced chemical vapour deposition in an evacuable chamber comprising the steps of:

   providing a process gas source;

   arranging, within the evacuable chamber, elongated metal rods in a rectangular matrix having m by n dimensions, wherein m and n are integers equal to or greater than 2, wherein the number of rods used is equal to the product of m and n, wherein the rods are positioned at the matrix vertices and are sufficiently spaced apart so that the individual substrates can be placed in the matrix interstitial spaces, and wherein each metal rod has an aperture at one end that is in communication with said gas source, with the aperture extending substantially the length of the rod to form a cylindrical bore within the rod, wherein the bore is in communication with the rod exterior through a series of holes in the rod, and further wherein the diameter of each hole is substantially less than the bore diameter so that gas pressure within the bore is substantially uniform;

   positioning the substrates at the matrix interstitial spaces;

   flowing process gas from the process gas source into the evacuable chamber through the holes of the elongated metal rods; and

   establishing a glow discharge plasma derived from the process gas.

FIG._1.

FIG._2.

FIG._4.

FIG._3.

EP 0 503 820 A1

**European Patent Office**

# EUROPEAN SEARCH REPORT

Application Number

EP 92 30 1810

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 257 620 (NUKEM GMBH) | 1 | C23C16/44 |
| Y | * column 7, line 5-25 * | 2,3 | C23C16/50 |
| A | * column 7, line 45 - line 57; figure 5 * | 4-9 | C23C16/40 |
| | --- | | |
| Y | GB-A-2 219 311 (VEB ELECTROMAT DRESDEN) | 2,3 | |
| A | * page 3, line 17 - line 34 * | 4-9 | |
| | --- | | |
| A | PATENT ABSTRACTS OF JAPAN vol. 9, no. 280 (E-356)(2003) 8 November 1985 & JP-A-60 123 021 ( FUJI DENKI SOUGOU KENKYUSHO K.K. ) 1 July 1985 * abstract * | 4-9 | |
| | ----- | | |

TECHNICAL FIELDS SEARCHED (Int. Cl.5)

C23C

The present search report has been drawn up for all claims

| Place of search | Date of completion of the search | Examiner |
|---|---|---|
| THE HAGUE | 09 JUNE 1992 | EKHULT H.U. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

9